(19) Europäisches Patentamt
European Patent Office
Office européen des brevets

(11) **EP 2 666 000 B1**

(12) **FASCICULE DE BREVET EUROPEEN**

(45) Date de publication et mention de la délivrance du brevet:
**31.05.2017 Bulletin 2017/22**

(21) Numéro de dépôt: **12700570.0**

(22) Date de dépôt: **20.01.2012**

(51) Int Cl.:
*G01K 7/02* *(2006.01)*     *G01K 17/00* *(2006.01)*
*G01K 17/20* *(2006.01)*     *H01L 35/32* *(2006.01)*
*H01L 35/34* *(2006.01)*

(86) Numéro de dépôt international:
**PCT/EP2012/050866**

(87) Numéro de publication internationale:
**WO 2012/098228 (26.07.2012 Gazette 2012/30)**

(54) **DISPOSITIF DE MESURE OU DE DÉTERMINATION DE LA DÉRIVÉE TEMPORELLE D'UN FLUX THERMIQUE ÉCHANGÉ ENTRE UN PREMIER MILIEU ET UN DEUXIÈME MILIEU**

VORRICHTUNG ZUR MESSUNG ODER BESTIMMUNG DER ZEITABLEITUNG EINES WÄRMEFLUSSES ZWISCHEN EINEM ERSTEN UND EINEM ZWEITEN MEDIUM

DEVICE FOR MEASURING OR DETERMINING THE TIME DERIVATIVE OF A HEAT FLOW EXCHANGED BETWEEN A FIRST MEDIUM AND A SECOND MEDIUM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.01.2011 FR 1150481**

(43) Date de publication de la demande:
**27.11.2013 Bulletin 2013/48**

(73) Titulaire: **Commissariat à l'énergie atomique et aux énergies alternatives 75015 Paris (FR)**

(72) Inventeurs:
• **CAROFF, Tristan**
  **F-38610 Gieres (FR)**
• **MINGO BISQUERT, Natalio**
  **F-38360 Sassenage (FR)**
• **REMONDIERE, Vincent**
  **F-38000 Grenoble (FR)**

(74) Mandataire: **Novaimo**
  **ActiTech 8**
  **60 avenue Marie Curie**
  **Archamps Technopole**
  **74166 Saint Julien en Genevois Cedex (FR)**

(56) Documents cités:
**FR-A1- 2 942 037**     **GB-A- 2 218 261**
**US-A- 3 296 034**

• **KOESTOER ET AL: "Zero method heat flux sensor", SENSORS AND ACTUATORS, ELSEVIER, vol. 7, no. 3, 1 juillet 1985 (1985-07-01) , pages 145-151, XP026552052, ISSN: 0250-6874, DOI: 10.1016/0250-6874(85)85016-2 [extrait le 1985-07-01]**

EP 2 666 000 B1

**Description**

La présente invention concerne le domaine technique de la mesure et de la détermination d'une caractéristique d'un flux thermique transmis d'un premier milieu à un deuxième milieu ou échangé entre un premier milieu et un deuxième milieu. L'invention concerne également un procédé de mesure ou de détermination d'une caractéristique d'un flux thermique transmis du premier milieu au deuxième milieu.

Cette invention s'applique notamment à des systèmes de mesure et de régulation de flux thermique.

La mesure de flux thermique permet de quantifier la déperdition ou le gain de chaleur d'un objet (par exemple une enceinte d'un four, un bâtiment...). Actuellement, aucun capteur ne permet de prédire en temps réel l'évolution de la quantité de chaleur traversant un objet et l'évolution de sa température. De tels dispositifs prédictifs seraient adaptés pour des systèmes de régulation thermique dans les bâtiments, pour la détection de départs d'incendie, de phénomènes physiques (changement de phase, croissance de matériaux, notamment de matériaux se cristallisant) et également pour la gestion thermique de systèmes électroniques intégrés.

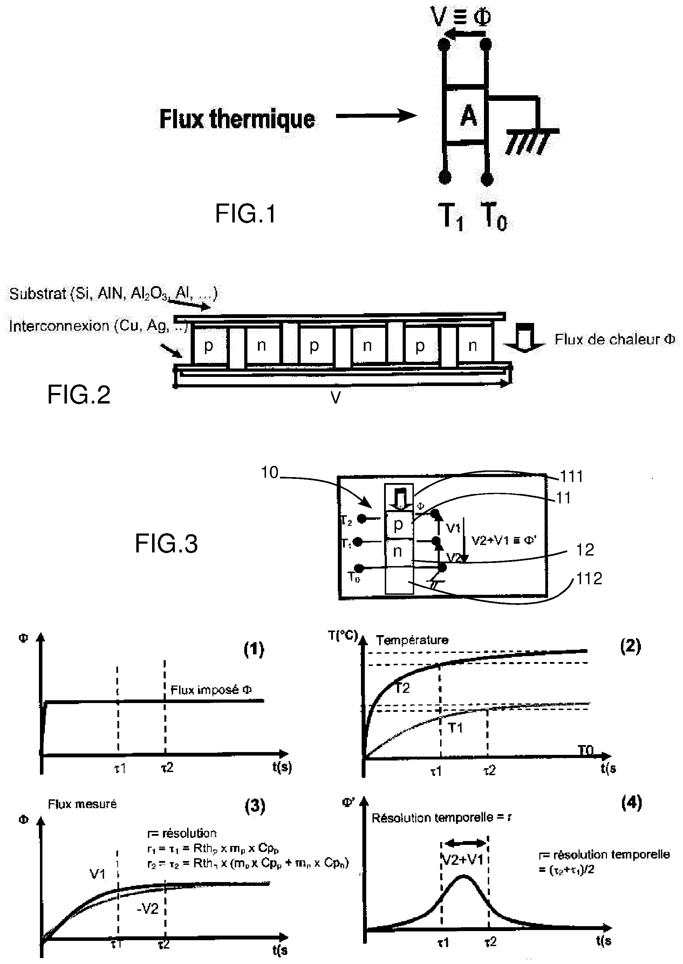

Il existe des convertisseurs thermoélectriques permettant de convertir une énergie thermique en énergie électrique grâce à l'effet « Seebeck », illustré à la figure 1. Avec un tel convertisseur, on peut déterminer le flux thermique $\Phi$ transféré d'un milieu dont la température est $T_0$ à un milieu dont la température est $T_1$. En effet, grâce à l'effet « Seebeck », une différence de potentiel V apparaît dans un matériau thermoélectrique A du convertisseur dont les extrémités sont soumises à un gradient thermique $T_1$-$T_0$. Le fonctionnement d'un tel convertisseur vérifie la relation suivante :

$$V = S_A \times (T_1 - T_0) = S_A \, Rth_A \times \Phi$$

Avec

$Rth_A$, la résistance thermique du matériau thermoélectrique A, et
$S_A$, le coefficient Seebeck du matériau thermoélectrique A.

En effet, le principe de l'effet Seebeck est le suivant : on considère un matériau conducteur ou semi-conducteur. Le matériau est traversé par un flux thermique $\Phi$, provoquant, compte tenu de sa résistance thermique $Rth_A$, un gradient de température $\Delta T = T_1 - T_0$ entre ses extrémités (avec $T_1 > T_0$), il se forme alors une différence de potentiel V entre les extrémités du conducteur.

Les matériaux thermoélectriques semi-conducteurs de type n, produisent une tension électrique proportionnelle à l'opposé du flux thermique qui les traverse et les matériaux thermoélectriques semi-conducteurs de type p produisent une tension électrique proportionnelle au flux thermique qui les traverse.

Les convertisseurs thermoélectriques et les fluxmètres thermoélectriques sont majoritairement constitués d'une série de plusieurs (N) couples d'éléments en matériaux thermoélectriques de coefficients Seebeck différents préférentiellement alternativement dopés n (ou de type n) et dopés p (ou de type p), les éléments étant connectés électriquement en série et thermiquement en parallèle, comme représenté à la figure 2. Ces éléments sont par exemple intercalés entre deux substrats, par exemple des substrats de type Si, AlN, $Al_2O_3$, Al, ... Par ailleurs, les éléments sont électriquement connectés les uns aux autres par exemple grâce à des éléments de connexion métallique, comme des éléments de connexion en cuivre ou en argent.

Lors du passage d'un flux thermique $\Phi$, le convertisseur thermoélectrique ou fluxmètre fournit alors une tension proportionnelle à ce flux :

$$V = N \, (S_p - S_n) \times \Delta T = N \times S_{pn} \times \Delta T = N \times S_{pn} \times \Phi \times Rth$$

Avec :

$S_{pn}$, le coefficient Seebeck différentiel entre les éléments p et n,
Rth, la résistance thermique du module composé de N couples thermoélectriques p-n connectés thermiquement en parallèle.

Le fluxmètre permet donc de mesurer la quantité de chaleur échangée entre deux objets ou deux milieux. Cette mesure est proportionnelle au gradient de température géométrique ou spatial entre les extrémités du fluxmètre ($\Delta T = dT/dx = T_{chaud} - T_{froid}$), mais n'est pas liée à la variation temporelle de température (dT/dt), et ne permet donc pas de prédire l'évolution de la température d'un objet traversé par un flux de chaleur. Le seul moyen d'y parvenir est de développer un capteur ou convertisseur permettant de fournir directement un signal proportionnel à la dérivée du flux thermique.

De manière générale, les dispositifs de mesure de flux ne donnent pas d'information prédictive sur l'évolution de la température du système, mais uniquement sur la quantité d'énergie qui pénètre dans un objet. Les fluxmètres sont des capteurs ou transducteurs qui permettent uniquement de mesurer un écart spatial de température.

Les documents connus ayant trait aux fluxmètres ne considèrent en aucun cas la mesure de dérivée (ou la mesure de variation temporelle) du flux au moyen d'un capteur.

On connaît des documents WO2008/024455, US5288147 et WO1999/019702 des systèmes calorimétriques mentionnant une mesure différentielle entre des thermocouples et qui ne permettent pas de quantifier une dérivée temporelle de flux thermique, mais uniquement une différence de température entre deux échantillons placés dans deux régions distinctes.

GB2218261 décrit un dispositif de mesure d'un flux thermique à l'aide de thermocouples disposés électriquement en série, mais thermiquement en parallèle.

Le brevet US7077563 décrit un dispositif permettant de mettre en évidence une variation thermique faible mais brutale liée au début de croissance d'un film mince et basé sur une mesure différentielle de deux flux en deux positions différentes. Ce dispositif, basé sur la soustraction de deux mesures de flux simultanées permet de mettre en évidence une variation de flux thermique, mais ne permet en aucun cas de mesurer la dérivée temporelle (variation) du flux thermique et de prédire l'évolution de la température du système.

Le but de l'invention est de fournir un dispositif de mesure ou de détermination d'une caractéristique de flux thermique permettant de remédier aux problèmes évoqués précédemment et améliorant les dispositifs connus de l'art antérieur. En particulier, l'invention propose un dispositif de mesure ou de détermination permettant de mesurer ou de déterminer une dérivée temporelle d'une valeur de l'intensité d'un flux thermique en temps réel.

Le dispositif selon l'invention est défini dans la revendication 1, et permet de mesurer ou de déterminer la dérivée par rapport au temps du flux thermique échangé entre un premier milieu et un deuxième milieu. Le dispositif comprend un premier moyen thermoélectrique et un deuxième moyen thermoélectrique. Les premier et deuxième moyens thermoélectriques sont électriquement disposés en série et thermiquement disposés en série. Le premier moyen thermoélectrique est d'une première nature (n) et le deuxième moyen thermoélectrique est d'une deuxième nature (p), les première et deuxième natures étant telles que le premier moyen thermoélectrique et le deuxième moyen thermoélectrique se polarisent en sens opposé sous l'effet d'un flux thermique de même direction et de même sens. Ainsi, il se crée entre les extrémités des moyens thermoélectriques des différences de potentiels électriques qui sont opposées. La nature du moyen est déterminée par le sens de la polarisation lorsque le moyen est traversé par un flux thermique donné.

Le produit capacité calorifique du deuxième moyen thermoélectrique-résistance thermique du deuxième moyen thermoélectrique peut être supérieur au produit capacité calorifique du premier moyen thermoélectrique-résistance thermique du premier moyen thermoélectrique.

L'aire de la section du dispositif, perpendiculaire au flux thermique, peut être constante.

La résistance thermique du deuxième moyen thermoélectrique peut être supérieure à la résistance thermique du premier moyen thermoélectrique.

La hauteur du deuxième moyen thermoélectrique peut être supérieure à la hauteur du premier moyen thermoélectrique et la résistivité thermique du deuxième moyen thermoélectrique peut être au moins sensiblement égale à la résistivité thermique du premier moyen thermoélectrique.

L'aire de la section du dispositif perpendiculaire au flux thermique peut ne pas être constante.

L'aire de la section du deuxième moyen thermoélectrique perpendiculaire au flux thermique peut être supérieure à l'aire de la section du premier moyen thermoélectrique perpendiculaire au flux thermique.

L'aire de la section du deuxième moyen thermoélectrique perpendiculaire au flux thermique peut être continûment variable.

La résistance thermique du deuxième moyen thermoélectrique peut être supérieure ou égale à la résistance thermique du premier moyen thermoélectrique.

Le produit de la résistance thermique et du coefficient Seebeck du deuxième moyen thermoélectrique peut être égal au produit de la résistance thermique et du coefficient Seebeck du premier moyen thermoélectrique.

Le premier moyen thermoélectrique peut comprendre plusieurs éléments thermoélectriques disposés électriquement en série et thermiquement en parallèle et le deuxième moyen thermoélectrique peut comprendre plusieurs éléments thermoélectriques disposés électriquement en série et thermiquement en parallèle.

Le premier moyen thermoélectrique et le deuxième moyen thermoélectrique peuvent être reliés électriquement en série via une connexion électrique assurant la conduction d'au moins une partie du flux thermique entre le premier moyen thermoélectrique et le deuxième moyen thermoélectrique.

Le premier moyen thermoélectrique peut comprendre au moins un élément thermoélectrique déposé sur un substrat et le deuxième moyen thermoélectrique peut comprendre au moins un élément thermoélectrique déposé sur le substrat.

Le dispositif peut être apte à déterminer ou à mesurer la dérivée nième avec n>1 du flux thermique et peut comprendre deux moyens thermoélectriques de types opposés, chaque moyen étant constitué de deux moyens aptes à déterminer ou à mesurer la dérivée d'ordre n-1, les moyens thermoélectriques étant tous disposés électriquement en série et thermiquement en série.

Les premier et deuxième moyens thermoélectriques peuvent être disposés en contact l'un avec l'autre de sorte que le flux thermique traverse successivement deux éléments thermoélectriques, notamment sans transiter dans un autre milieu entre les deux.

Les premier et deuxième moyens thermoélectriques peuvent s'étendre parallèlement ou sensiblement parallèlement l'un à l'autre.

Les premier et deuxième moyens thermoélectriques peuvent comprendre chacun des faces d'entrée du flux thermique et de sortie du flux thermique parallèles ou sensiblement parallèles, ces faces étant toutes parallèles ou sensiblement parallèles les unes aux autres.

Le dispositif peut être destiné à être agencé de sorte que le flux thermique soit perpendiculaire ou sensiblement perpendiculaire aux directions selon lesquelles s'étendent les premier et deuxième moyens thermoélectriques.

Le dispositif peut être destiné à être agencé de sorte que le flux thermique soit parallèle ou sensiblement parallèle aux directions selon lesquelles s'étendent les premier et deuxième moyens thermoélectriques.

Selon l'invention, le système de mesure ou de détermination comprend au moins un premier dispositif défini précédemment et un deuxième dispositif défini précédemment, les premier et deuxième dispositifs de mesure étant électriquement disposés en série et étant thermiquement disposés en parallèle.

Selon l'invention, le procédé de mesure ou de détermination d'une dérivée par rapport au temps d'un flux thermique échangé entre un premier milieu et un deuxième milieu est défini dans la revendication 15, à l'aide d'un dispositif défini précédemment, et comprend les étapes suivantes :

- Fournir un premier moyen thermoélectrique,
- Fournir un deuxième moyen thermoélectrique,
- Disposer thermiquement et électriquement en série les premier et deuxième moyens entre le premier milieu et le deuxième milieu,
- Déterminer ou mesurer la tension électrique aux bornes de l'ensemble des premier et deuxième moyens,
- Déduire de la détermination ou de la mesure précédente la dérivée par rapport au temps du flux thermique circulant dans les premier et deuxième moyens entre le premier milieu et le deuxième milieu.

Les dessins annexés représentent, à titre d'exemples, différents modes de réalisation d'un dispositif de mesure selon l'invention.

La figure 1 est un schéma de principe du fonctionnement d'un capteur de mesure d'un flux thermique connu de l'art antérieur.

La figure 2 est un schéma de principe du fonctionnement d'un capteur de mesure d'un flux thermique plus complexe connu de l'art antérieur.

La figure 3 est un schéma de principe d'un premier mode de réalisation d'un dispositif de mesure selon l'invention et un ensemble de diagrammes expliquant le fonctionnement de ce premier mode de réalisation.

La figure 4 est un schéma de principe d'un deuxième mode de réalisation d'un dispositif de mesure selon l'invention et un ensemble de diagrammes expliquant le fonctionnement de ce deuxième mode de réalisation.

Les figures 5 et 6 sont des schémas de principe d'une première variante du premier mode de réalisation du dispositif de mesure selon l'invention.

Les figures 7 à 9 représentent différents schémas de principe d'une première famille de variantes du deuxième mode de réalisation du dispositif de mesure selon l'invention.

La figure 10 représente un schéma de principe d'une deuxième variante du deuxième mode de réalisation du dispositif de mesure selon l'invention.

La figure 11 représente des schémas de principe d'autres variantes du deuxième mode de réalisation du dispositif de mesure selon l'invention.

La figure 12 représente une autre variante du premier mode de réalisation d'un dispositif de mesure selon l'invention.

La figure 13 représente une autre variante du deuxième mode de réalisation d'un dispositif de mesure selon l'invention.

La figure 14 représente une première variante d'un troisième mode de réalisation du dispositif de mesure selon l'invention.

La figure 15 représente une deuxième variante du troisième mode de réalisation du dispositif de mesure selon l'invention.

La figure 16 représente une troisième variante du troisième mode de réalisation du dispositif de mesure selon l'invention.

La figure 17 représente une quatrième variante du troisième mode de réalisation du dispositif de mesure selon l'invention.

La figure 18 représente une cinquième variante du troisième mode de réalisation du dispositif de mesure selon l'invention.

La figure 19 représente une sixième variante du troisième mode de réalisation du dispositif de mesure selon l'invention.

Les figures 20 à 22 représentent des graphiques de simulations de fonctionnement de dispositifs de mesure selon l'invention.

Selon l'invention, un dispositif de mesure ou de détermination, notamment en temps réel, d'une caractéristique d'un flux thermique échangé entre un premier milieu et un deuxième milieu comprend un premier moyen thermoélectrique et un deuxième moyen thermoélectrique, les premier et deuxième moyens thermoélectriques étant électriquement disposés en série et étant thermiquement disposés en série, le premier moyen thermoélectrique et le deuxième moyen thermoélectrique se polarisant en sens opposés sous l'effet d'un flux thermique de même direction et de même sens.
Le premier moyen thermoélectrique est d'une première nature et le deuxième moyen thermoélectrique étant d'une deuxième nature de sorte que le premier moyen thermoélectrique et le deuxième moyen thermoélectrique se polarisent électriquement en sens opposés sous l'effet d'un flux thermique de même direction et de même sens
Un tel dispositif de mesure est donc obtenu en associant en série de manière spécifique des moyens thermoélectriques de types différents, notamment de type p (ou à dopage p) et de type n (ou à dopage n).
Comme on le verra plus bas, le dispositif peut être généralisé et permettre de mesurer en temps réel le flux thermique, sa dérivée temporelle et/ou sa dérivée seconde temporelle et/ou sa dérivée ne temporelle.
Le principe du dispositif et donc le principe de la mesure de variations de variations du flux en temps réel est basé sur la soustraction de deux signaux électriques décalés dans le temps.
En effet, la dérivée par rapport au temps d'un signal physique peut être calculée de manière discrète par :

$$F'(t) = dF(t)/dt = \Delta F/\Delta t = [F(t_1)-F(t_0)]/(t_1-t_0)$$

Et, les dérivées ne peuvent être calculées de manière discrète par :

$$F''(t) = d^2F(t)/dt^2 = [F'(t_1)-F'(t_0)]/(t_1-t_0)$$

$$F'''(t) = d^3F(t)/dt^3 = [F''(t_1)-F''(t_0)]/(t_1-t_0)$$

$$F^{n+1}(t) = d^nF(t)/dt^n = [F^n(t_1)-F^n(t_0)]/(t_1-t_0)$$

Si l'on place deux moyens thermoélectriques de natures différentes (n et p) thermiquement et électriquement en série, on obtient alors un signal égal à l'addition de deux signaux électriques opposés et décalés temporellement. On remarque qu'une telle structure est à proscrire pour la mesure du flux thermique lui-même car l'addition de deux signaux opposés aboutit à un signal nul à l'équilibre (ou en régime stationnaire), et donc ne permet pas de mesurer le flux.

Ensuite, pour la mesure de la dérivée seconde du flux, il faut connecter en série électriquement et thermiquement deux systèmes tels que précédemment évoqués, c'est-à-dire deux moyens de mesure de dérivée du flux en série thermiquement et électriquement, ces moyens de mesure de dérivée étant polarisés en inverse, par exemple une structure pn disposée thermiquement et électriquement en série avec une structure np, soit une structure pnnp ou une structure nppn.

De même, pour mesurer la dérivée ne il faut connecter en série électriquement et thermiquement $2^n/2$ dispositifs tels que précédemment évoqués, c'est-à-dire $2^n/2$ moyens de mesure de dérivée du flux disposés en série thermiquement et électriquement, ces moyens de mesure de dérivée étant polarisés en inverse, par exemple une structure nppnpnnp pour la dérivée $3^e$ et une structure nppnpnnppnpnppn ou pnnpnppnppnpnnp pour la dérivée $4^e$.

Un premier mode de réalisation d'un dispositif de mesure selon l'invention est représenté à la figure 3. Le dispositif de mesure 10 comprend un premier moyen thermoélectrique 11, comme par exemple un matériau conducteur de type p, et un deuxième moyen thermoélectrique 12, comme par exemple un matériau conducteur de type n. Le premier moyen thermoélectrique et le deuxième moyen thermoélectrique sont en contact l'un contre l'autre au niveau d'une de leurs faces, ces faces étant perpendiculaires au flux thermique. Le premier moyen thermoélectrique est en outre couplé thermiquement à un premier milieu 111 et le deuxième moyen thermoélectrique est en outre couplé thermiquement à un deuxième milieu 112. La température $T_2$ du premier milieu 111 étant supérieure à la température $T_0$ du deuxième milieu 112, un flux thermique $\Phi$ s'écoule du premier milieu vers le deuxième milieu au travers du dispositif de mesure. Le premier moyen thermoélectrique et le deuxième moyen thermoélectrique étant thermiquement disposés en série, le flux thermique s'écoule d'abord dans le premier moyen thermoélectrique puis dans le deuxième moyen thermoélectrique. On peut mesurer au niveau de l'interface entre les premier et deuxième moyens thermoélectriques une température $T_1$ comprise entre les températures $T_0$ et $T_2$.

De même, les premier et deuxième moyens thermoélectriques sont disposés électriquement en série. Ainsi, on recueille entre la face du premier moyen thermoélectrique en contact avec le premier milieu et l'interface entre les premier et deuxième moyens thermoélectriques, une tension électrique V1. De même, on recueille entre l'interface se trouvant entre les premier et deuxième moyens thermoélectriques et la face du deuxième moyen thermoélectrique en contact avec le deuxième milieu, une tension électrique V2. On recueille, en outre, entre la face du premier moyen thermoélectrique en contact avec le premier milieu et la face du deuxième moyen thermoélectrique en contact avec le deuxième milieu, une tension électrique V telle que V=V1+V2. Les tensions V1 et V2 sont de signes opposés du fait que les premier et deuxième moyens thermoélectriques sont de types différents. La tension électrique V est une image de la dérivée temporelle $\Phi'$ du flux thermique $\Phi$ s'écoulant dans le dispositif de mesure 10, par exemple la dérivée $\Phi'$ du flux thermique est proportionnelle à la tension électrique V. On peut donc réaliser de manière simple un dispositif de mesure de la dérivée par rapport au temps d'un flux thermique.

Sur quatre diagrammes de la figure 3, les évolutions temporelles de différentes grandeurs physiques relatives au premier mode de réalisation sont représentées.

Sur un premier diagramme (1), on représente l'évolution du flux thermique $\Phi$ imposé dans le dispositif de mesure. Le flux thermique entrant dans le dispositif de mesure a une intensité variant comme un créneau d'intensité $\Phi$. Le flux thermique entre par le premier moyen thermoélectrique et sort par le deuxième moyen thermoélectrique. La constante de temps thermique du premier moyen thermoélectrique est égale à $T_p = Rth_p \times m_p \times Cp_p$, et la constante de temps thermique du deuxième moyen thermoélectrique est égale à $T_n = Rth_n \times (m_p \times Cp_p + m_n \times Cp_n)$, avec :

$T_p$ et $T_n$, les constantes de temps thermique au niveau des premier et deuxième moyens thermoélectriques,
$Rth_p$ et $Rth_n$, les résistances thermiques des premier et deuxième moyens thermoélectriques,
$m_p$ et $m_n$, les masses des premier et deuxième moyens thermoélectriques,
$Cp_p$ et $Cp_n$, les chaleurs massiques des premier et deuxième moyens thermoélectriques.

Étant donné que $m_p \times Cp_p < m_p \times Cp_p + m_n \times Cp_n$, les températures $T_1$ et $T_2$ ont des évolutions temporelles décalées. Ce comportement thermique se traduit par une évolution décalée dans le temps des tensions aux bornes du deuxième moyen thermoélectrique (V2) et aux bornes du premier moyen thermoélectrique (V1). L'addition des signaux électriques (décalés dans le temps et de signes opposés) générés par les premier et deuxième moyens thermoélectriques est alors une image de la dérivée du flux thermique, notamment elle est proportionnelle à la dérivée du flux thermique. La tension électrique V est donnée par la relation suivante : $V=V1+V2=K \times (\Phi(t_0+\Delta t)-\Phi(t_0))=d\Phi/dt$ (avec K une constante dépendant des coefficients Seebeck des premier et deuxième moyens thermoélectriques).

Les évolutions des tensions électriques sont représentées sur le diagramme (3). Les évolutions des températures T0, T1 et T2 sont représentées sur le diagramme (2). Les évolutions de la dérivée temporelle du flux thermique sont représentées sur le diagramme (4).

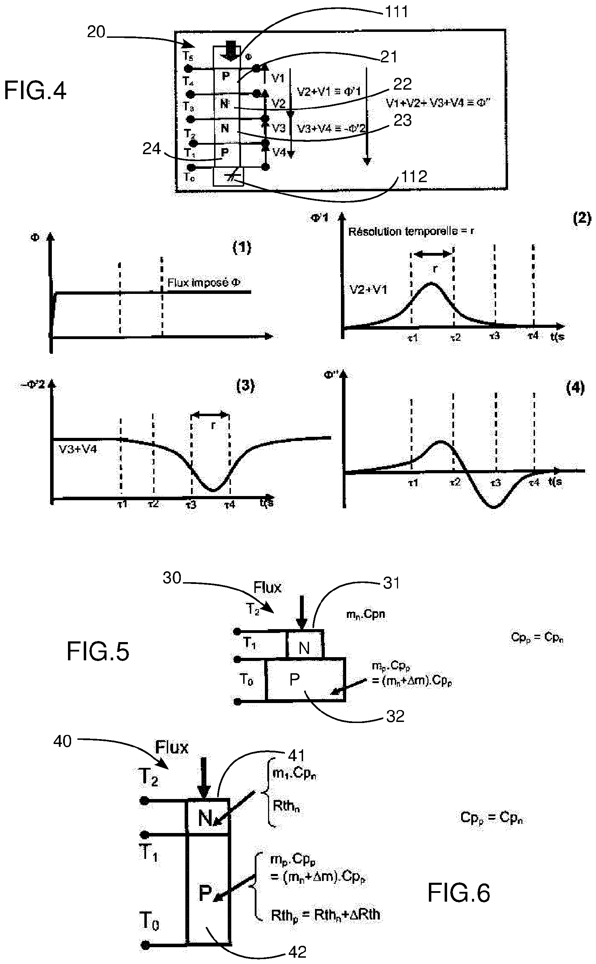

Un deuxième mode de réalisation d'un dispositif de mesure 20 selon l'invention est représenté à la figure 4. Le dispositif de mesure 20 comprend un premier moyen thermoélectrique 21, comme par exemple un matériau conducteur de type p, un deuxième moyen thermoélectrique 22, comme par exemple un matériau conducteur de type n, un troisième moyen thermoélectrique 23, comme par exemple un matériau semi-conducteur de type n et un quatrième moyen thermoélectrique 24, comme par exemple un matériau semi-conducteur de type p. Le premier moyen thermoélectrique et le deuxième moyen thermoélectrique sont en contact l'un contre l'autre au niveau d'une de leurs faces, le deuxième moyen thermoélectrique et le troisième moyen thermoélectrique sont en contact l'un contre l'autre au niveau d'une de leurs faces, le troisième moyen thermoélectrique et le quatrième moyen thermoélectrique sont en contact l'un contre l'autre au niveau d'une de leurs faces. Le premier moyen thermoélectrique est en outre couplé thermiquement à un premier milieu 111 et le quatrième moyen thermoélectrique est en outre couplé thermiquement à un deuxième milieu 112. La température $T_4$ du premier milieu 111 étant supérieure à la température $T_0$ du deuxième milieu 112, un flux thermique $\Phi$ s'écoule du premier milieu vers le deuxième milieu au travers du dispositif de mesure. Le premier moyen thermoélectrique, le deuxième moyen thermoélectrique, le troisième moyen thermoélectrique et le quatrième moyen thermoélectrique étant thermiquement disposés en série, le flux thermique s'écoule d'abord dans le premier moyen thermoélectrique puis dans le deuxième moyen thermoélectrique, puis dans le troisième moyen thermoélectrique et enfin dans le quatrième moyen thermoélectrique. On peut mesurer, au niveau de l'interface entre les premier et deuxième moyens thermoélectriques, une température $T_3$ ; au niveau de l'interface entre les deuxième et troisième moyens thermoélectriques, une température $T_2$ ; au niveau de l'interface entre les troisième et quatrième moyens thermoélectriques une température $T_1$ ; au niveau de l'interface entre les premier et deuxième moyens thermoélectriques, une température $T_1$ comprise entre les températures $T_0$ et $T_4$.

De même, les premier, deuxième, troisième et quatrième moyens thermoélectriques sont disposés électriquement en série. Ainsi, on recueille entre la face du premier moyen thermoélectrique en contact avec le premier milieu et l'interface entre les premier et deuxième moyens thermoélectrique, une tension électrique V1. On recueille entre l'interface entre les premier et deuxième moyens thermoélectriques et l'interface entre les deuxième et troisième moyens thermoélectriques, une tension électrique V2. On recueille entre l'interface entre les deuxième et troisième moyens thermoélectriques et l'interface entre les troisième et quatrième moyens thermoélectriques, une tension électrique V3. De même, on recueille entre l'interface entre les troisième et quatrième moyens thermoélectriques et la face du quatrième moyen thermoélectrique en contact avec le deuxième milieu, une tension électrique V4. On recueille, en outre, entre la face du premier moyen thermoélectrique en contact avec le premier milieu et la face du quatrième moyen thermoélectrique en contact avec le deuxième milieu, une tension électrique V telle que V=V1+V2+V3+V4. Les tensions V1 et V4 d'une part et V2 et V3 d'autre part sont de signes opposés du fait que les premier et quatrième moyens thermoélectriques et que les deuxième et troisième moyens thermoélectriques sont de types différents. La tension électrique V est une image de la dérivée seconde temporelle $\Phi''$ du flux thermique $\Phi$ s'écoulant dans le dispositif de mesure 20, par exemple la dérivée seconde $\Phi''$ est proportionnelle à la tension électrique V. On peut donc réaliser de manière simple un dispositif de mesure de la dérivée seconde par rapport au temps d'un flux thermique.

Sur quatre diagrammes de la figure 4, les évolutions temporelles de différentes grandeurs physiques relatives au deuxième mode de réalisation sont représentées.

Sur un premier diagramme (1), on représente l'évolution du flux thermique $\Phi$ imposé dans le dispositif de mesure. Le flux thermique entrant dans le dispositif de mesure a une intensité variant comme un créneau d'intensité $\Phi$. Le flux thermique entre par le premier moyen thermoélectrique et sort par le quatrième moyen thermoélectrique.

Les évolutions de la tension électrique V1+V2 est représentée sur le diagramme (2). Les évolutions de la tension électrique V3+V4 est représentée sur le diagramme (3). Les évolutions de la tension électrique V est représentée sur le diagramme (4).

L'ajout en série de deux dispositifs de mesure de types opposés selon le premier mode de réalisation permet l'obtention d'un dispositif de mesure conforme au deuxième mode de réalisation. Un tel deuxième mode de réalisation permet la mesure ou la détermination, en temps réel, du flux thermique, de la dérivée du flux thermique par rapport au temps et de la dérivée seconde du flux thermique par rapport au temps.

En remarque, un dispositif de mesure ayant une structure pnnp ou nppn peut être remplacée par une structure pnp ou npn dans laquelle les moyens thermoélectriques centraux ont les propriétés thermiques et électriques des deux éléments thermoélectriques centraux connectés électriquement et thermiquement en série, notamment lorsque l'on souhaite mesurer la dérivée seconde du flux thermique sans nécessairement mesurer la dérivée première du flux thermique.

Dans les différents modes de réalisation, les moyens thermoélectriques peuvent être de toute nature. De préférence, ils sont réalisés en matériau conducteurs, notamment en matériaux conducteurs de type p et en matériau conducteurs de type n.

Dans les modes de réalisation de dispositifs de mesure précédemment décrits, la mise en série des moyens thermoélectriques n et p selon une configuration spécifiquement définie permet de mesurer en temps réel les variations d'un flux thermique, mais comme les signaux provenant des moyens thermoélectriques n et p se soustraient, le signal de sortie est drastiquement réduit. Il est donc préférable de concevoir des géométries spécifiques permettant de fortement décaler temporellement les signaux électriques de mesure de flux le long du dispositif afin d'augmenter le signal électrique en sortie lors des variations de flux.

Par ailleurs, outre le décalage temporel des signaux électriques, l'utilisation de systèmes comprenant plusieurs (N) dispositifs de mesure de dérivée du flux thermique disposés en série électriquement et en parallèle thermiquement, permet d'obtenir une meilleure sensibilité. En effet, le signal électrique produit alors une plus forte amplitude pour une même variation de flux thermique:

$$V_{système} = N \times V_{dispositif}.$$

Par ailleurs, une différence de capacité calorifique et une différence de résistance thermique entre les moyens thermoélectriques permettent de décaler temporellement l'évolution des signaux le long du transfert de chaleur, et ainsi d'augmenter la sensibilité de la structure de mesure lors de variations de flux thermique.

De façon générale, pour obtenir ce décalage temporel, il faut que les dispositifs de mesure de types opposés (1 et 2) vérifient l'équation :

$$M_2 c_{P2} \times R_{th2} \geq m_1 c_{P1} \times R_{th1}$$

lorsque le flux passe du milieu 1 au milieu 2. On peut donc jouer sur les paramètres masse (donc volume), capacité calorifique et résistance thermique.

Une première variante d'exécution du premier mode de réalisation met à profit cet aspect. Dans cette première variante, le dispositif de mesure, représenté à la figure 5, comprend un premier moyen thermoélectrique 31 de masse $m_n$ et de capacité calorifique massique $Cp_n$ et un deuxième moyen thermoélectrique 32 de masse $m_p$ et de capacité calorifique massique $Cp_p$, les premier et deuxième moyens étant disposés en série électriquement et thermiquement. Dans cette première variante, la capacité calorifique du deuxième moyen thermoélectrique est supérieure à la capacité calorifique du premier moyen thermoélectrique et les résistances thermiques des premier et deuxième moyens thermoélectriques sont égales ou sensiblement égales. Par exemple, la capacité calorifique du deuxième moyen thermoélectrique est supérieure de 10% à la capacité calorifique du premier moyen thermoélectrique. Cette différence étant à l'origine du décalage temporel, elle est choisie en fonction de la précision souhaitée.

On considère que $m_p.Cp_p > m_n.Cp_n$, que $Rth_n = Rth_p$ et que $Cp_p = Cp_n = Cp$, $Rth_p$ étant la résistance thermique du deuxième moyen et $Rth_n$ étant la résistance thermique du premier moyen.

Dans ce cas spécifique, la constante de temps du deuxième moyen thermoélectrique est décalée d'un facteur $(m_n + \Delta m).Cp$ par rapport à celle du premier moyen thermoélectrique, au lieu d'être seulement décalée d'un facteur $m_n.Cp$ si $m_n = m_p$ dans un cas plus conventionnel.

Une deuxième variante d'exécution du premier mode de réalisation met à profit cet aspect. Dans cette deuxième variante, le dispositif de mesure, représenté à la figure 6, comprend un premier moyen thermoélectrique 41 de masse $m_n$ et de capacité calorifique massique $Cp_n$ et un deuxième moyen thermoélectrique 42 de masse $m_p$ et de capacité calorifique massique $Cp_p$, les premier et deuxième moyens étant disposés en série électriquement et thermiquement. Dans cette deuxième variante, la capacité calorifique du deuxième moyen thermoélectrique est supérieure à la capacité calorifique du premier moyen thermoélectrique. Par exemple, la capacité calorifique du deuxième moyen thermoélectrique est supérieure de 10% à la capacité calorifique du premier moyen thermoélectrique. La résistance thermique du deuxième moyen thermoélectrique est supérieure à la résistance thermique du premier moyen thermoélectrique. Par exemple, la résistance thermique du deuxième moyen thermoélectrique est supérieure de 10% à la résistance thermique du premier moyen thermoélectrique.

On considère que $m_p.Cp_p > m_n.Cp_n$, que $Rth_p > Rth_n$ et que $Cp_p = Cp_n = Cp$, $Rth_p$ étant la résistance thermique du deuxième moyen et $Rth_n$ étant la résistance thermique du premier moyen.

Dans ce cas spécifique, la constante de temps du deuxième moyen thermoélectrique est décalée d'un facteur $(m_n + \Delta m).Cp \times (1 + \Delta Rth)$ par rapport à celle du premier moyen thermoélectrique, au lieu d'être seulement décalée d'un facteur $m_n.Cp$ si $m_n = m_p$ dans un cas plus conventionnel.

Pour améliorer la sensibilité des mesures de dérivées de flux thermique, il est donc préférable que les capacités calorifiques des moyens thermoélectriques composant un dispositif de mesure soient différentes (régulièrement croissantes vers le deuxième milieu, c'est-à-dire le milieu le plus froid ou vers lequel le flux thermique se dirige).

Alternativement ou complémentairement, pour améliorer la sensibilité des mesures de dérivées de flux thermique, il est préférable que les résistances thermiques des moyens thermoélectriques composant un dispositif de mesure soient différentes (régulièrement croissantes vers le deuxième milieu, c'est-à-dire le milieu le plus froid ou vers lequel le flux thermique se dirige). On conserve de préférence le produit de la résistance thermique et du coefficient Seebeck constant.

Par ailleurs, il est intéressant d'utiliser des moyens thermoélectriques (n et p, np et pn, nppn et pnnp, ....) générant des signaux électriques égaux à l'équilibre afin d'obtenir un signal nul à l'équilibre (correspondant à une dérivée nulle), c'est-à-dire qu'avec N moyens thermoélectriques : $V_1 = -V_2 = V_3 = -V_4 = V_N = \Delta T \times S = Rth_m \times \Phi \times S_m$ à l'équilibre (avec $S_{np}$ le coefficient Seebeck du moyen thermoélectrique et $Rth_m$ la résistance thermique de chaque moyen thermoélectrique). Cette condition est obtenue pour : $Rth_m \times S_m$=constante.

Par la suite, on appelle « dispositif du premier type » un dispositif comprenant des moyens thermoélectriques dont les capacités calorifiques croissent vers le deuxième milieu et dont les résistances thermiques sont égales et on appelle « dispositif du deuxième type » un dispositif comprenant des moyens thermoélectriques dont les capacités calorifiques croissent vers le deuxième milieu et dont les résistances thermiques croissent vers le deuxième milieu, le produit de la résistance thermique et du coefficient Seebeck restant constant.

Le principal avantage des dispositifs du premier type est le suivant : il n'est pas nécessaire de recourir à des procédés différents lors de la fabrication pour obtenir des coefficients Seebeck différents pour les différents moyens thermoélectriques.

Le principal avantage des dispositifs du deuxième type est le suivant : il est possible de réaliser des dispositifs ayant une section constante le long du transfert de chaleur.

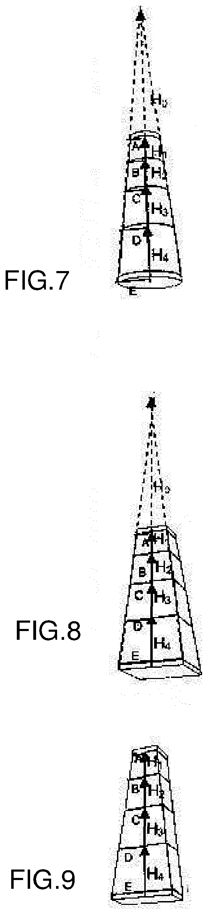

Pour les dispositifs de mesure de premier type, une évolution linéaire de la section le long du dispositif de mesure et donc le long du transfert de chaleur permet un transfert optimum du courant et de la chaleur, sans discontinuité (pas de marches entre les éléments). Les figures 7 à 9 représentent trois géométries qui permettent de réaliser des dispositifs de mesure du premier type.

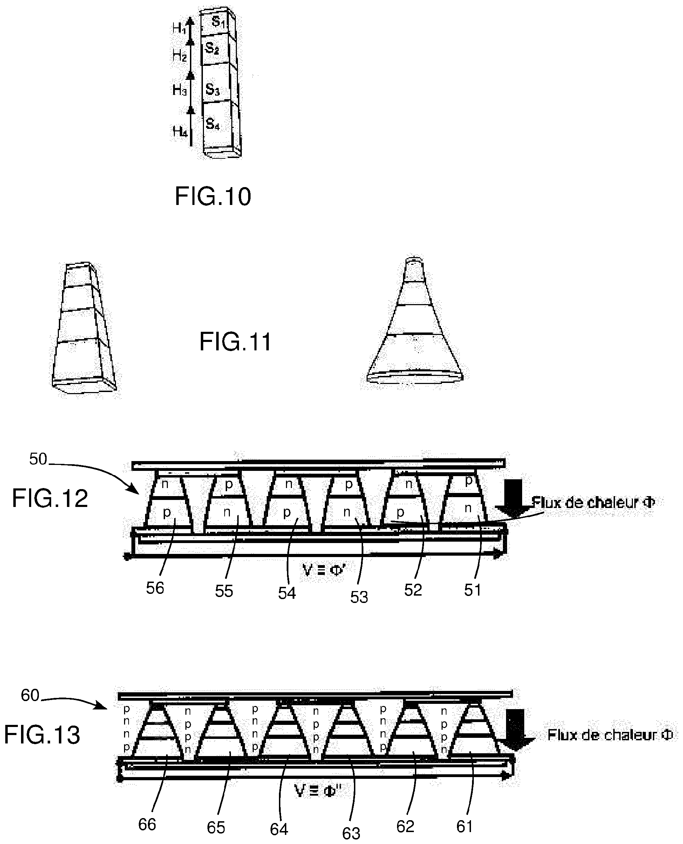

Pour les dispositifs de mesure de deuxième type, il est avantageux de garder une section constante pour faciliter la fabrication, notamment la fabrication des moyens thermoélectriques. La figure 10 représente une géométrie qui permet de réaliser des dispositifs de mesure du deuxième type.

Comme représenté à la figure 11, d'autres géométries de dispositifs de mesure peuvent être envisagées, notamment :

- une géométrie dans laquelle le produit de la résistance thermique et du coefficient Seebeck reste constant et dans laquelle la section du dispositif varie le long du chemin de transfert de chaleur, et
- une géométrie dans laquelle la résistance thermique des moyens thermoélectriques successifs reste constante, dans laquelle les coefficients Seebeck des différents moyens thermoélectriques sont égaux et la section du dispositif varie le long du chemin de transfert de chaleur de manière continue mais non linéaire.

Classiquement, il est possible d'utiliser tout type de matériaux thermoélectriques pour concevoir un dispositif de mesure de dérivée de flux thermique selon l'invention. Cependant, les matériaux présentant un fort coefficient Seebeck et surtout un grand facteur de mérite ZT (dans la gamme de température envisagée) seront préférentiellement utilisés. Par exemple, on peut utiliser du $Bi_2Te_3$ pour une température moyenne d'environ 100°C, du SiGe pour une température moyenne d'environ 600°C, du $Mg_2SiSn$ et du $Zn_4Sb_3$ pour une température moyenne d'environ 300-400°C. Le facteur de mérite ZT est un nombre adimensionnel qui caractérise les performances thermoélectriques globales d'un matériau : $ZT = S^2.(\sigma/\lambda)$, avec S le coefficient Seebeck, $\sigma$ la conductivité électrique et $\lambda$ la conductivité thermique. Par ailleurs, l'utilisation de matériaux thermoélectriques nanostructurés est préconisée car ils favorisent la diffusion des phonons aux interfaces entre nanoagrégats, ce qui permet de réduire considérablement leur conductivité thermique et par la même occasion d'améliorer leurs performances thermoélectriques, ainsi que la sensibilité des dispositifs de mesure de flux thermiques et variation de flux thermiques.

Le dispositif de mesure peut être un système comprenant plusieurs dispositifs de mesure selon le premier mode de réalisation ou selon le deuxième mode de réalisation, ces dispositifs de mesure étant reliés en parallèle thermiquement et connectés électriquement en série. Un tel système permet d'additionner les réponses électriques de chaque dispositif de mesure et garantit une meilleure sensibilité de mesure. Un système de mesure comprenant N dispositifs de mesure est N fois plus sensible qu'un seul dispositif de mesure.

Une autre variante du premier mode de réalisation d'un dispositif de mesure 50 ou système de mesure selon l'invention est représenté à la figure 12. Le système de mesure 50 comprend différents dispositifs de mesure 51, 52, 53, 54, 55 et 56 connectés électriquement en série et disposés thermiquement en parallèle. Chaque dispositif de mesure comprend uniquement deux moyens thermoélectriques et permet de produire un signal représentatif de la dérivée du flux thermique.

Une autre variante du deuxième mode de réalisation d'un dispositif de mesure 60 ou système de mesure selon l'invention est représenté à la figure 13. Le système de mesure 60 comprend différents dispositifs de mesure 61, 62, 63, 64, 65 et 66 connectés électriquement en série et disposés thermiquement en parallèle. Chaque dispositif de mesure comprend quatre moyens thermoélectriques et permet de produire un signal représentatif de la dérivée seconde du flux thermique.

Dans les deux variantes représentées aux figures 12 et 13, les dispositifs 51-56 et 61-66 présentent des structures de types opposés : le dispositif 51 a une structure pn, le dispositif 52 suivant a une structure np, le dispositif 53 suivant à une structure pn et ainsi de suite, de même, le dispositif 61 a une structure nppn, le dispositif 62 suivant a une structure pnnp, le dispositif 63 suivant a une structure nppn et ainsi de suite.

Dans un troisième mode de réalisation, le dispositif de mesure est un système comprenant plusieurs dispositifs de mesure connus de l'art antérieur, ces dispositifs de mesure étant reliés en parallèle thermiquement et connectés électriquement en série. Un tel système permet d'additionner les réponses électriques de chaque dispositif de mesure.

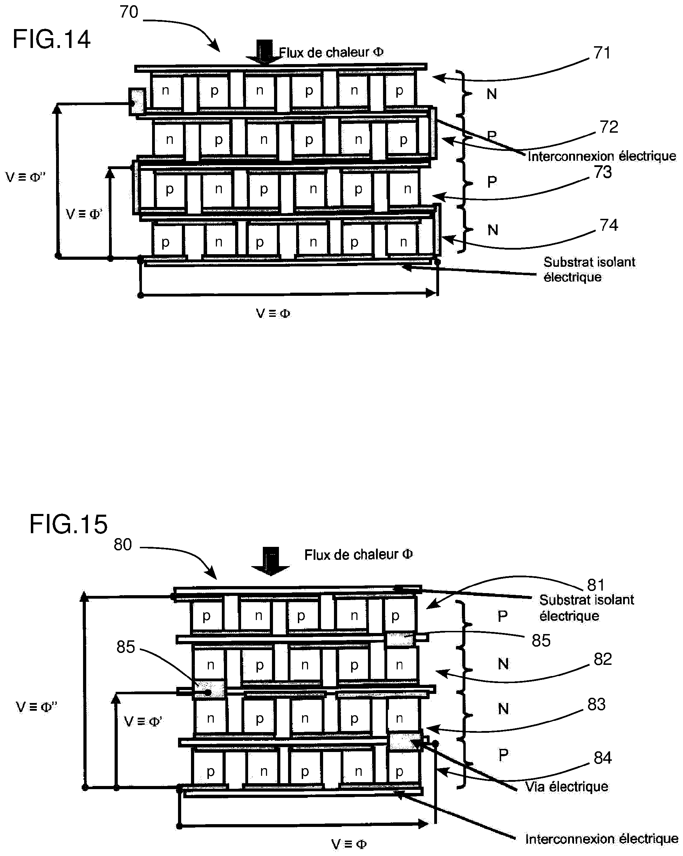

Une première variante du troisième mode de réalisation d'un dispositif de mesure 70 ou système de mesure selon l'invention est représenté à la figure 14. Le système de mesure 70 comprend différents dispositifs de mesure 71, 72, 73 et 74 connectés électriquement en série et disposés thermiquement en série. Chaque dispositif de mesure comprend un dispositif de mesure tel que représenté à la figure 2. Chacun de ces dispositifs de mesure est d'une première nature ou d'une deuxième nature et se polarise dans un premier sens ou dans un deuxième sens (opposé au premier sens) sous l'effet d'un même flux thermique. Les dispositifs 71 et 74 sont d'une première nature et les dispositifs 72 et 73 sont d'une deuxième nature. Ainsi, on retrouve, aux bornes des dispositifs 73 et 74 ou des dispositifs 72 et 71, des tensions images de la dérivée du flux thermique et, aux bornes de l'ensemble des dispositifs 71 à 74, une tension image de la dérivée seconde du flux thermique. On retrouve également, aux bornes de chacun des dispositifs 71 à 74, une tension image du flux thermique ou une tension image opposée.

Une deuxième variante du troisième mode de réalisation d'un dispositif de mesure 80 ou système de mesure selon l'invention est représenté à la figure 15. Le système de mesure 80 comprend différents dispositifs de mesure 81, 82, 83 et 84 connectés électriquement en série et disposés thermiquement en série. Il diffère de la première variante du quatrième mode de réalisation en ce que des connexions électriques 85 entre les différents dispositifs de mesure permettent de transmettre une partie du flux thermique. Ces connexions électriques relient différents moyens thermoélectriques de dispositifs de mesure successifs.

Cette configuration spécifique présente l'avantage de permettre une mesure simultanée du flux thermique, de sa dérivée et de sa dérivée seconde, en utilisant des connexions électriques entre les différents dispositifs 71, 72, 73, 74 ou 81, 82, 83, 84.

Le dimensionnement de l'épaisseur et du volume des moyens thermoélectriques permet de concevoir des dispositifs de mesure de flux thermique avec différentes résolutions temporelles. L'utilisation d'éléments massifs de 500 $\mu$m à quelques millimètres d'épaisseur permet de réaliser des dispositifs de mesure de variation de flux thermique avec des résolutions temporelles assez larges de l'ordre de la milliseconde à l'ordre de la seconde. L'utilisation d'éléments microscopiques (100 $\mu$m à 500 $\mu$m), notamment grâce à des technologies d'impression (jet d'encre, sérigraphie, ...), permet de réaliser des dispositifs de mesure de variation de flux thermique avec des résolutions temporelles de plusieurs $\mu$s à quelques ms.

Enfin, l'utilisation d'éléments microscopiques (100 nm à 100 $\mu$m) réalisés notamment grâces à des technologies de dépôt de couches minces utilisées en microélectronique (PVD, CVD, ...) permet de réaliser des dispositifs de mesure de variation de flux thermique à faible capacité thermique avec des résolutions temporelles extrêmement petites de l'ordre de la picoseconde à la microseconde.

Pour information, l'utilisation de technologies d'impression permet de concevoir de dispositifs de mesure de grandes tailles avec un grand nombre d'éléments à moindre coût de production.

Dans d'autres variantes du troisième mode de réalisation, on utilise comme moyens thermoélectriques des couches minces déposées sur un substrat conducteur (par exemple Si, $Al_2O_3$, AlN...). Il est intéressant de remarquer que le flux thermique passe quasi exclusivement dans le substrat, et les moyens thermoélectriques ne font que prendre la même température que le substrat sur lequel ils sont déposés. Dans ce cas, pour concevoir des dispositifs de mesure optimisés comme décrits précédemment, les résistances thermiques et les capacités thermiques à prendre en compte pour le dimensionnement géométrique sont essentiellement celles du substrat présent sous les moyens thermoélectriques.

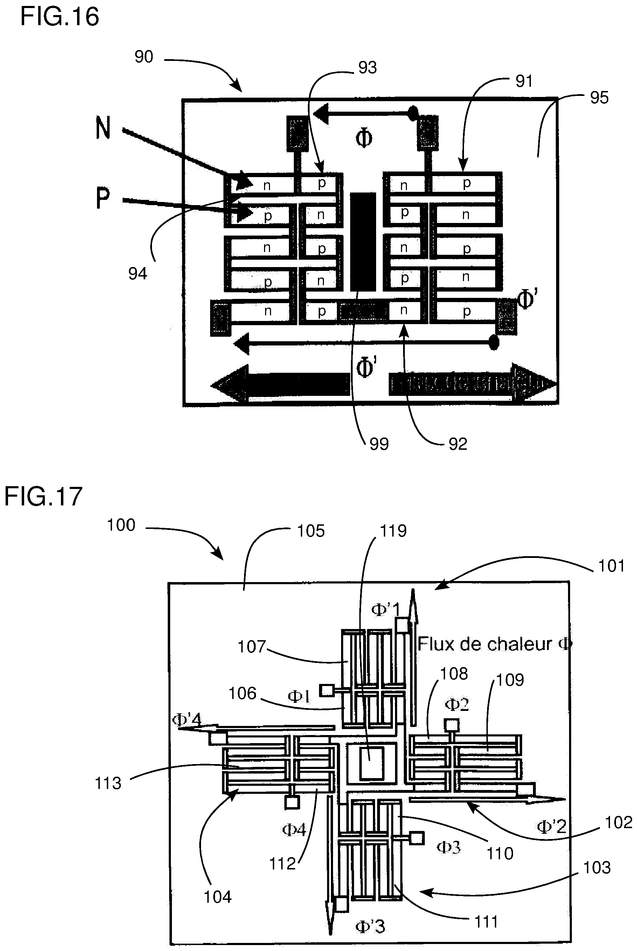

Une troisième variante du troisième mode de réalisation d'un dispositif de mesure 90 selon l'invention est représenté à la figure 16. Le système de mesure 90 comprend différents dispositifs de mesure 91, 92, 93 et 94 connectés électriquement en série et disposés thermiquement en série. Chaque dispositif de mesure comprend un dispositif de mesure tel que représenté à la figure 2, à la différence que les moyens thermoélectriques sont des couches déposées sur un substrat 95. Le dispositif permet la mesure de dérivées du flux thermique circulant dans le substrat depuis un premier milieu chaud 99.

Une quatrième variante du troisième mode de réalisation d'un dispositif de mesure 100 selon l'invention est représenté à la figure 17. Le système de mesure 100 comprend différents modules 101, 102, 103, 104 disposés radialement sur un substrat 105. Chaque module comprend deux dispositifs de mesure 106, 107 ; 108, 109 ; 110, 111 ; 112, 113 connectés électriquement en série et disposés thermiquement en série. Chaque dispositif de mesure comprend un dispositif de mesure tel que représenté à la figure 2, à la différence que les moyens thermoélectriques sont des couches déposées sur le substrat 105. Le dispositif permet la mesure de dérivées du flux thermique circulant dans le substrat depuis un premier milieu chaud 119 selon les quatre directions du substrat.

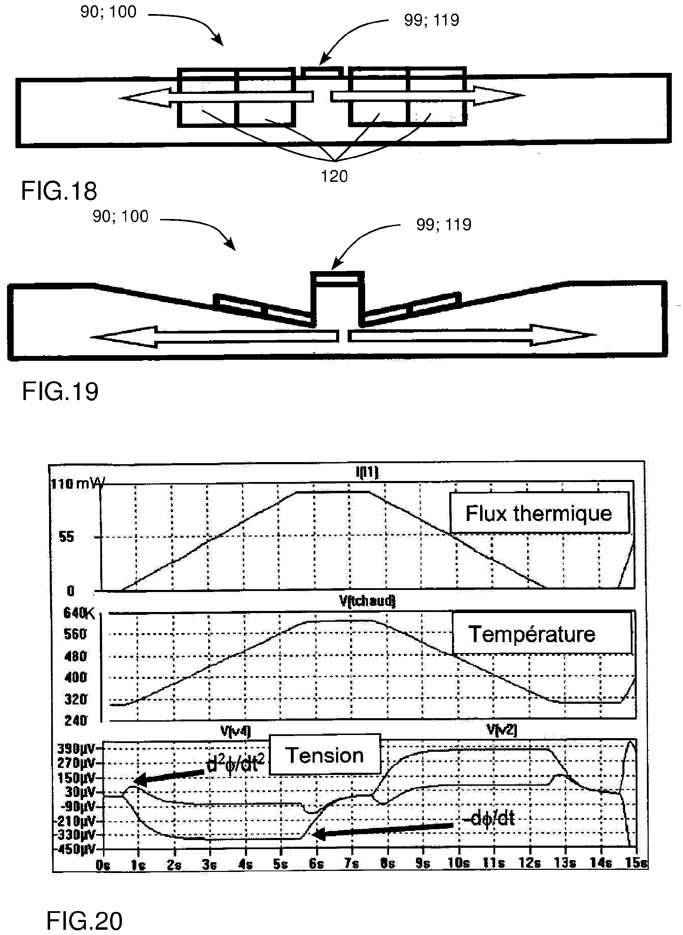

Comme représenté à la figure 18, afin d'optimiser la troisième ou quatrième variante du troisième mode de réalisation, il peut être prévu de conformer le substrat de sorte à intégrer dans celui-ci, sous les moyens thermoélectriques, des éléments 120 de capacités calorifiques différentes.

Alternativement ou complémentairement, comme représenté à la figure 19, afin d'optimiser la troisième ou quatrième variante du troisième mode de réalisation, il peut être prévu de conformer le substrat par exemple par micro usinage de sorte que la capacité calorifique et/ou la résistance thermique du substrat évolue le long du flux thermique.

Bien évidemment, ces dispositifs de mesure peuvent être extrapolés pour mesurer la dérivée nième (ne) du flux thermique.

Les graphiques des figures 20 à 22 obtenus par simulation numérique montrent clairement que les dispositifs selon l'invention permettent de mesurer en temps réel des dérivées d'un flux thermique d'ordre supérieur ou égal à 1.

Le graphique de la figure 20 représente le comportement d'un dispositif de mesure en $Bi_2Te_3$ de 1 mm par 1 mm par 1 mm suite à une excitation thermique lente de 100mW.

En dimensionnant correctement le dispositif de mesure, il est possible d'augmenter la résolution temporelle et de distinguer des signaux thermiques brefs et même des phénomènes thermiques ponctuels ou quasi ponctuels.

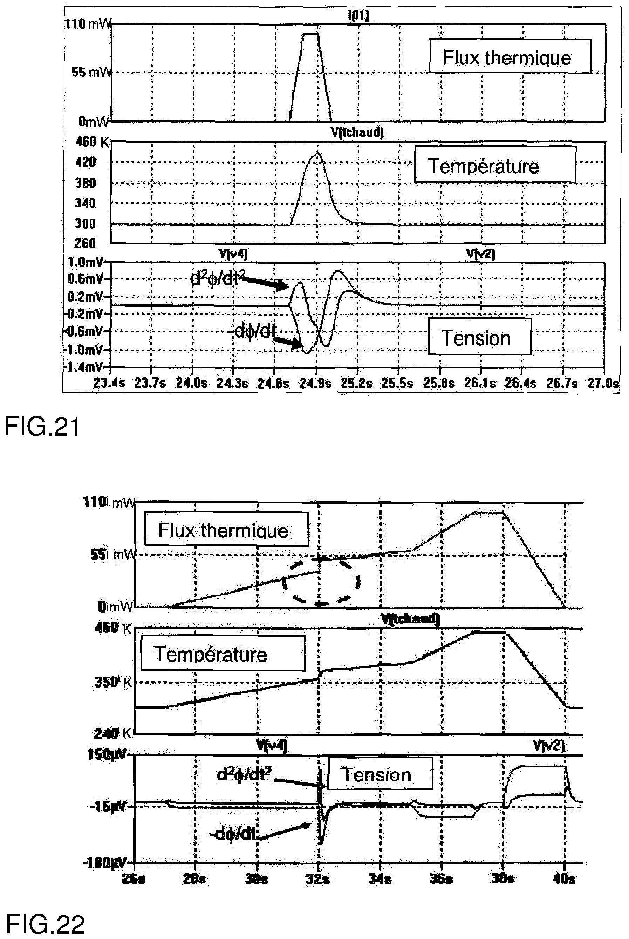

Par exemple, le graphique de la figure 21 représente le comportement d'un dispositif de mesure en couches minces de $Bi_2Te_3$ suite à une excitation thermique rapide de 110mW.

Par exemple encore, le graphique de la figure 22 représente le comportement d'un dispositif de mesure en couches minces de $Bi_2Te_3$ lors d'un événement thermique ponctuel à t=32s.

Ces quelques simulations montrent que le dispositif de mesure selon l'invention permet de mesurer des variations de flux thermique en temps réel et de mettre en évidence des événements thermiques ponctuels.

Le dispositif de mesure selon l'invention est adapté aux applications suivantes :

- régulation de température, la dérivée du flux thermique permettant de prédire l'évolution de la température (dT/dt = pente de variation de T°C),
- détection d'événements physiques, comme les dérivée et dérivée seconde du flux thermique et de la température permettant de détecter des variations brutales de température causées par un événement physicochimique (début de croissance cristalline...), détection de départ d'incendie,
- imagerie médicale, la conversion de rayons X par scintillateur entraîne une production de chaleur. Un dispositif de mesure selon l'invention permet de prévenir des défaillances thermiques liées à cette augmentation de chaleur.
- capteur multi pixel de variation de température permettant de produire une cartographie de variations de température utilisable en surveillance vidéo, notamment pour détecter un changement de comportement.

L'invention porte aussi sur un procédé de mesure ou de détermination d'une caractéristique d'un flux thermique échangé entre un premier milieu et un deuxième milieu. Le procédé comprend les étapes suivantes :

- Fournir un premier moyen thermoélectrique,
- Fournir un deuxième moyen thermoélectrique,
- Disposer thermiquement et électriquement en série les premier et deuxième moyens entre le premier milieu et le deuxième milieu,
- Déterminer ou mesurer la tension électrique aux bornes de l'ensemble des premier et deuxième moyens,
- Déduire de la détermination ou de la mesure précédente une caractéristique du flux thermique circulant dans les premier et deuxième moyens entre le premier milieu et le deuxième milieu.

Dans tout ce document, le terme « moyen thermoélectrique » ne couvre de préférence pas la notion de « thermocouple ». Le terme « moyen thermoélectrique » couvre un solide en un seul et même matériau thermoélectrique, voire un agencement de plusieurs solides constitués de matériaux différents, montés thermiquement en parallèle ou en série et montés électriquement en parallèle ou en série.

**Revendications**

**1.** Dispositif (10; 20; 30; 40; 70; 80; 90; 100) de mesure ou de détermination d'une dérivée par rapport au temps d'un flux thermique ($\Phi$) échangé entre un premier milieu (111) et un deuxième milieu (112), le dispositif comprenant un premier moyen thermoélectrique (11 ; 21 ; 31 ; 41 ; 71 ; 81 ; 91 ; 101) et un deuxième moyen thermoélectrique (12 ; 22 ; 32 ; 42; 72; 82; 92; 102), les premier et deuxième moyens thermoélectriques étant électriquement disposés en série et étant thermiquement disposés en série, le premier moyen thermoélectrique étant d'une première nature (n) et le deuxième moyen thermoélectrique étant d'une deuxième nature (p), les première et deuxième natures étant telles que le premier moyen thermoélectrique et le deuxième moyen thermoélectrique se polarisent en sens opposé sous l'effet d'un flux thermique de même direction et de même sens, le dispositif étant destiné à être agencé de sorte que le flux thermique soit parallèle ou sensiblement parallèle aux directions selon lesquelles s'étendent les premier et deuxième moyens thermoélectriques.

2. Dispositif selon la revendication 1, **caractérisé en ce que** le produit capacité calorifique du deuxième moyen thermoélectrique - résistance thermique du deuxième moyen thermoélectrique est supérieur au produit capacité calorifique du premier moyen thermoélectrique - résistance thermique du premier moyen thermoélectrique.

3. Dispositif selon l'une des revendications précédentes, **caractérisé en ce que** l'aire de la section du dispositif perpendiculaire au flux thermique est constante.

4. Dispositif selon la revendication précédente, **caractérisé en ce que** la résistance thermique du deuxième moyen thermoélectrique est supérieure à la résistance thermique du premier moyen thermoélectrique.

5. Dispositif selon la revendication précédente, **caractérisé en ce que** la hauteur du deuxième moyen thermoélectrique est supérieure à la hauteur du premier moyen thermoélectrique et **en ce que** la résistivité thermique du deuxième moyen thermoélectrique est au moins sensiblement égale à la résistivité thermique du premier moyen thermoélectrique.

6. Dispositif selon l'une des revendications 1 et 2, **caractérisé en ce que** l'aire de la section du dispositif perpendiculaire au flux thermique n'est pas constante.

7. Dispositif selon la revendication précédente, **caractérisé en ce que** l'aire de la section du deuxième moyen thermoélectrique perpendiculaire au flux thermique est supérieure à l'aire de la section du premier moyen thermoélectrique perpendiculaire au flux thermique.

8. Dispositif selon la revendication précédente, **caractérisé en ce que** l'aire de la section du deuxième moyen thermoélectrique perpendiculaire au flux thermique est continûment variable.

9. Dispositif selon la revendication précédente, **caractérisé en ce que** la résistance thermique du deuxième moyen thermoélectrique est supérieure ou égale à la résistance thermique du premier moyen thermoélectrique.

10. Dispositif selon l'une des revendications précédentes, **caractérisé en ce que** le produit de la résistance thermique et du coefficient Seebeck du deuxième moyen thermoélectrique est égal au produit de la résistance thermique et du coefficient Seebeck du premier moyen thermoélectrique.

11. Dispositif selon l'une des revendications précédentes, **caractérisé en ce que** le premier moyen thermoélectrique comprend plusieurs éléments thermoélectriques disposés électriquement en série et thermiquement en parallèle et **en ce que** le deuxième moyen thermoélectrique comprend plusieurs éléments thermoélectriques disposés électriquement en série et thermiquement en parallèle.

12. Dispositif selon la revendication précédente, **caractérisé en ce que** le premier moyen thermoélectrique et le deuxième moyen thermoélectrique sont reliés électriquement en série via une connexion électrique (85) assurant la conduction d'au moins une partie du flux thermique entre le premier moyen thermoélectrique et le deuxième moyen thermoélectrique.

13. Dispositif selon l'une des revendications précédentes,

    - **caractérisé en ce que** le premier moyen thermoélectrique comprend au moins un élément thermoélectrique déposé sur un substrat et **en ce que** le deuxième moyen thermoélectrique comprend au moins un élément thermoélectrique déposé sur le substrat, et/ou
    - **caractérisé en ce qu'**il est apte à déterminer ou mesurer la dérivée nième avec n>1 du flux thermique et comprend deux moyens thermoélectriques de types opposés, chaque moyen étant constitué de deux moyens aptes à déterminer ou à mesurer la dérivée d'ordre n-1, les moyens thermoélectriques étant tous disposés électriquement en série et thermiquement en série, et/ou
    - **caractérisé en ce que** les premier et deuxième moyens thermoélectriques sont disposés en contact l'un avec l'autre de sorte que le flux thermique traverse successivement deux éléments thermoélectriques, notamment sans transiter dans un autre milieu entre les deux, et/ou
- **caractérisé en ce que** les premier et deuxième moyens thermoélectriques s'étendent parallèlement ou sensiblement parallèlement l'un à l'autre, et/ou
- **caractérisé en ce que** les premier et deuxième moyens thermoélectriques comprennent chacun des faces d'entrée du flux thermique et de sortie du flux thermique parallèles ou sensiblement parallèles, ces faces étant toutes parallèles ou sensiblement parallèles les unes aux autres

14. Système de mesure ou de détermination (50 ; 60) comprenant au moins un premier dispositif (51 ; 61) selon l'une des revendications précédentes et un deuxième dispositif (52 ; 62) selon l'une des revendications précédentes, **caractérisé en ce que** les premier et deuxième dispositifs de mesure sont électriquement disposés en série et sont thermiquement disposés en parallèle.

15. Procédé de mesure ou de détermination d'une dérivée par rapport au temps d'un flux thermique ($\Phi$) échangé entre un premier milieu (111) et un deuxième milieu (112), à l'aide du dispositif selon l'une des revendications 1 à 13, comprenant les étapes suivantes :

- Fournir un premier moyen thermoélectrique (11 ; 21+22; 71+72 ; 81+82),
- Fournir un deuxième moyen thermoélectrique (12 ; 23+24 ; 73+74 ; 83+84),
- Disposer thermiquement et électriquement en série les premier et deuxième moyens entre le premier milieu et le deuxième milieu,
- Déterminer ou mesurer la tension électrique aux bornes de l'ensemble des premier et deuxième moyens,
- Déduire de la détermination ou de la mesure précédente une dérivée par rapport au temps du flux thermique circulant dans les premier et deuxième moyens entre le premier milieu et le deuxième milieu.

**Patentansprüche**

1. Vorrichtung (10; 20; 30; 40; 70; 80; 90; 100) zur Messung oder Bestimmung einer Zeitabweichung eines Wärmeflusses ($\phi$), der zwischen einem ersten Medium (111) und einem zweiten Medium (112) ausgetauscht wird, wobei die Vorrichtung ein erstes thermoelektrisches Mittel (11; 21; 31; 41; 71; 81; 91; 101) und ein zweites thermoelektrisches Mittel (12; 22; 32; 42; 72; 82; 92; 102) umfasst, wobei die ersten und zweiten thermoelektrischen Mittel elektrisch in Serie angeordnet sind und thermisch in Serie angeordnet sind, wobei das erste thermoelektrische Mittel von einer ersten Natur (n) ist, und das zweite thermoelektrische Mittel von einer zweiten Natur (p) ist, wobei die ersten und zweiten Naturen derart sind, dass sich das erste thermoelektrische Mittel und das zweite thermoelektrische Mittel in entgegengesetzte Richtung unter der Wirkung eines Wärmeflusses derselben Ausrichtung und derselben Richtung polarisieren, wobei die Vorrichtung dazu bestimmt ist, derart angeordnet zu werden, dass der Wärmefluss parallel oder im Wesentlichen parallel zu den Richtungen ist, in die sich die ersten und zweiten thermoelektrischen Mittel erstrecken.

2. Vorrichtung nach Anspruch 1, **dadurch gekennzeichnet, dass** das Produkt aus Wärmeleistung des zweiten thermoelektrischen Mittels und thermischem Widerstand des zweiten thermoelektrischen Mittels größer ist als das Produkt aus Wärmeleistung des ersten thermoelektrischen Mittels und thermischem Widerstand des ersten thermoelektrischen Mittels.

3. Vorrichtung nach einem der vorhergehenden Ansprüche, **dadurch gekennzeichnet, dass** der Bereich des Querschnitts der Vorrichtung senkrecht auf den Wärmefluss konstant ist.

4. Vorrichtung nach dem vorhergehenden Anspruch, **dadurch gekennzeichnet, dass** der thermische Widerstand des zweiten thermoelektrischen Mittels größer als der thermische Widerstand des ersten thermoelektrischen Mittels ist.

5. Vorrichtung nach dem vorhergehenden Anspruch, **dadurch gekennzeichnet, dass** die Höhe des zweiten thermoelektrischen Mittels größer als die Höhe des ersten thermoelektrischen Mittels ist, und dass die thermische Widerstandsfähigkeit des zweiten thermoelektrischen Mittels zumindest im Wesentlichen gleich der thermischen Widerstandsfähigkeit des ersten thermoelektrischen Mittels ist.

6. Vorrichtung nach einem der Ansprüche 1 und 2, **dadurch gekennzeichnet, dass** der Bereich des Querschnitts der Vorrichtung senkrecht auf den Wärmefluss nicht konstant ist.

7. Vorrichtung nach dem vorhergehenden Anspruch, **dadurch gekennzeichnet, dass** der Bereich des Querschnitts des zweiten thermoelektrischen Mittels senkrecht auf den Wärmefluss größer als der Bereich des Querschnitts des ersten thermoelektrischen Mittels senkrecht auf den Wärmefluss ist.

8. Vorrichtung nach dem vorhergehenden Anspruch, **dadurch gekennzeichnet, dass** der Bereich des Querschnitts des zweiten thermoelektrischen Mittels senkrecht auf den Wärmefluss kontinuierlich variabel ist.

9. Vorrichtung nach dem vorhergehenden Anspruch, **dadurch gekennzeichnet, dass** der thermische Widerstand des zweiten thermoelektrischen Mittels größer oder gleich dem thermischen Widerstand des ersten thermoelektrischen Mittels ist.

10. Vorrichtung nach einem der vorhergehenden Ansprüche, **dadurch gekennzeichnet, dass** das Produkt aus dem thermischen Widerstand und dem Seebeck-Koeffizienten des zweiten thermoelektrischen Mittels gleich dem Produkt aus dem thermischen Widerstand und dem Seebeck-Koeffizienten des ersten thermoelektrischen Mittels ist.

11. Vorrichtung nach einem der vorhergehenden Ansprüche, **dadurch gekennzeichnet, dass** das erste thermoelektrische Mittel mehrere thermoelektrische Elemente umfasst, die elektrisch in Serie und thermisch parallel angeordnet sind, und dass das zweite thermoelektrische Mittel mehrere thermoelektrische Elemente umfasst, die elektrisch in Serie und thermisch parallel angeordnet sind.

12. Vorrichtung nach dem vorhergehenden Anspruch, **dadurch gekennzeichnet, dass** das erste thermoelektrische Mittel und das zweite thermoelektrische Mittel elektrisch in Serie über einen elektrischen Anschluss (85) verbunden sind, der die Leitung mindestens eines Teils des Wärmeflusses zwischen dem ersten thermoelektrischen Mittel und dem zweiten thermoelektrischen Mittel gewährleistet.

13. Vorrichtung nach einem der vorhergehenden Ansprüche,

- **dadurch gekennzeichnet, dass** das erste thermoelektrische Mittel mindestens ein thermoelektrisches Element umfasst, das auf ein Substrat aufgebracht ist, und dass das zweite thermoelektrische Mittel mindestens ein thermoelektrisches Element umfasst, das auf das Substrat aufgebracht ist, und/oder
- **dadurch gekennzeichnet, dass** sie geeignet ist, die n-te Ableitung, wobei n>1, des Wärmeflusses zu bestimmen oder zu messen, und zwei thermoelektrische Mittel vom entgegengesetzten Typ umfasst, wobei jedes Mittel von zwei Mitteln gebildet ist, die geeignet sind, die Ableitung der Ordnung n-1 zu bestimmen oder zu messen, wobei die thermoelektrischen Mittel alle elektrisch in Serie und thermisch in Serie angeordnet sind, und/oder
- **dadurch gekennzeichnet, dass** die ersten und zweiten thermoelektrischen Mittel in Kontakt miteinander angeordnet sind, so dass der Wärmefluss nacheinander zwei thermoelektrische Elemente durchquert, insbesondere ohne in einem anderen Medium zwischen den beiden zu verlaufen, und/oder
- **dadurch gekennzeichnet, dass** sich die ersten und zweiten thermoelektrischen Mittel parallel oder im Wesentlichen parallel zueinander erstrecken, und/oder
- **dadurch gekennzeichnet, dass** die ersten und zweiten thermoelektrischen Mittel jeweils Eintrittsflächen des Wärmeflusses und Austrittsflächen des Wärmeflusses umfassen, die parallel oder im Wesentlichen parallel sind, wobei diese Flächen alle zueinander parallel oder im Wesentlichen parallel sind.

14. Messungs- oder Bestimmungssystem (50; 60), umfassend mindestens eine erste Vorrichtung (51; 61) nach einem der vorhergehenden Ansprüche, und eine zweite Vorrichtung (52; 62) nach einem der vorhergehenden Ansprüche, **dadurch gekennzeichnet, dass** die ersten und zweiten Messvorrichtungen elektrisch in Serie angeordnet und thermisch parallel angeordnet sind.

15. Verfahren zur Messung oder Bestimmung einer Zeitabweichung eines Wärmeflusses ($\phi$), der zwischen einem ersten Medium (111) und einem zweiten Medium (112) ausgetauscht wird, mit Hilfe der Vorrichtung nach einem der Ansprüche 1 bis 13, umfassend die folgenden Schritte:

- Bereitstellen eines ersten thermoelektrischen Mediums (11; 21+22; 71+72; 81+82),
- Bereitstellen eines zweiten thermoelektrischen Mittels (12; 23+24; 73+74; 83+84),
- Anordnen der ersten und zweiten Mittel zwischen dem ersten Medium und dem zweiten Medium thermisch und elektrisch in Serie,
- Bestimmen oder Messen der elektrischen Spannung an den Klemmen der Gesamtheit der ersten und zweiten Mittel,
- aus der vorhergehenden Bestimmung oder Messung Ableiten einer Zeitabweichung des Wärmeflusses, der in den ersten und zweiten Mitteln zwischen dem ersten Medium und dem zweiten Medium zirkuliert.

**Claims**

1. Device (10; 20; 30; 40; 70; 80; 90; 100) for measuring or evaluating a time derivative of a heat flux (Φ) exchanged between a first medium (111) and a second medium (112), especially a time derivative of the heat flux, the device comprising a first thermoelectric means (11; 21; 31; 41; 71; 81; 91; 101) and a second thermoelectric means (12; 22; 32; 42; 72; 82; 92; 102), the first and second thermoelectric means being electrically connected in series and thermally connected in series, the first thermoelectric means being of a first nature (n) and the second thermoelectric means being of a second nature (p), the first and second natures being such that the first thermoelectric means and the second thermoelectric means polarize with opposite polarities under the effect of a heat flux having a given direction and a given sign, the device being intended to be arranged so that the heat flux is parallel or substantially parallel to the directions in which the first and second thermoelectric means extend.

2. Device according to Claim 1, **characterized in that** the product of the heat capacity of the second thermoelectric means and the thermal resistance of the second thermoelectric means is greater than the product of the heat capacity of the first thermoelectric means and the thermal resistance of the first thermoelectric means.

3. Device according to either one of the preceding claims, **characterized in that** the cross-sectional area of the device perpendicular to the heat flux is constant.

4. Device according to the preceding claim, **characterized in that** the thermal resistance of the second thermoelectric means is higher than the thermal resistance of the first thermoelectric means.

5. Device according to the preceding claim, **characterized in that** the height of the second thermoelectric means is greater than the height of the first thermoelectric means and **in that** the thermal resistivity of the second thermoelectric means is at least substantially equal to the thermal resistivity of the first thermoelectric means.

6. Device according to either one of Claims 1 and 2, **characterized in that** the cross-sectional area of the device perpendicular to the heat flux is not constant.

7. Device according to the preceding claim, **characterized in that** the cross-sectional area of the second thermoelectric means perpendicular to the heat flux is larger than the cross-sectional area of the first thermoelectric means perpendicular to the heat flux.

8. Device according to the preceding claim, **characterized in that** the cross-sectional area of the second thermoelectric means perpendicular to the heat flux is continuously variable.

9. Device according to the preceding claim, **characterized in that** the thermal resistance of the second thermoelectric means is higher than or equal to the thermal resistance of the first thermoelectric means.

10. Device according to one of the preceding claims, **characterized in that** the product of the thermal resistance and the Seebeck coefficient of the second thermoelectric means is equal to the product of the thermal resistance and the Seebeck coefficient of the first thermoelectric means.

11. Device according to one of the preceding claims, **characterized in that** the first thermoelectric means comprises a number of thermoelectric elements electrically connected in series and thermally connected in parallel and **in that** the second thermoelectric means comprises a number of thermoelectric elements electrically connected in series and thermally connected in parallel.

12. Device according to the preceding claim, **characterized in that** the first thermoelectric means and the second thermoelectric means are electrically connected in series via an electrical connection (85) ensuring at least some of the heat flux is conducted between the first thermoelectric means and the second thermoelectric means.

13. Device according to one of the preceding claims,

- **characterized in that** the first thermoelectric means comprises at least one thermoelectric element deposited on a substrate and **in that** the second thermoelectric means comprises at least one thermoelectric element deposited on the substrate, and/or

- **characterized in that** it is able to evaluate or measure the nth derivative, where n>1, of the heat flux and comprises two thermoelectric means of opposite types, each means consisting of two means able to evaluate or to measure the derivative of order n-1, the thermoelectric means all being electrically and thermally connected in series, and/or

- **characterized in that** the first and second thermoelectric means are placed in contact with each other so that the heat flux passes through two thermoelectric elements in succession, especially without passing through another medium intermediate between them, and/or

- **characterized in that** the first and second thermoelectric means extend parallel or substantially parallel to each other, and/or

- **characterized in that** the first and second thermoelectric means each comprise parallel or substantially parallel heat flux input and output sides, these sides all lying parallel or substantially parallel to one another.

14. Evaluating or measuring system (50; 60) comprising at least one first device (51; 61) according to one of the preceding claims, and one second device (52, 62) according to one of the preceding claims, **characterized in that** the first and second measuring devices are electrically connected in series and thermally connected in parallel.

15. Method for measuring or evaluating a time derivative of a heat flux ($\Phi$) exchanged between a first medium (111) and a second medium (112), by means of the device according to one of claims 1 to 13, comprising the following steps:

- providing a first thermoelectric means (11; 21+22; 71+72; 81+82);
- providing a second thermoelectric means (12; 23+24; 73+74; 83+84);
- thermally and electrically connecting the first and second means in series between the first medium and the second medium;
- evaluating or measuring the electrical voltage across the terminals of the set of first and second means;
- deducing from the preceding evaluation or measurement a time derivative of the heat flux flowing through the first and second means between the first medium and the second medium.

$$V \equiv \Phi$$

Flux thermique →

A

$T_1$  $T_0$

## FIG.1

Substrat (Si, AIN, Al₂O₃, Al, ...)

Interconnexion (Cu, Ag, ...)

| p | n | p | n | p | n |

Flux de chaleur Φ

V

## FIG.2

## FIG.3

10 — 111 — 11

Φ

$T_2$  p  V1

$T_1$  n  V2+V1 ≡ Φ'  — 12

$T_0$  — 112

(1)

Φ

Flux imposé Φ

τ1  τ2  t(s)

(2)

T(°C)  Température

T2

T1

T0

τ1  τ2  t(s)

(3)

Flux mesuré

Φ

r = résolution
$r_1 = \tau_1 = Rth_p \times m_p \times Cp_p$
$r_2 = \tau_2 = Rth_n \times (m_p \times Cp_p + m_n \times Cp_n)$

V1

-V2

τ1  τ2  t(s)

(4)

Φ'  Résolution temporelle = r

V2+V1

r = résolution temporelle
= $(\tau_2 + \tau_1)/2$

τ1  τ2  t(s)

FIG.4

20

T5
111

P
21
V1

T4
V2+V1 ≡ Φ'1
22

N'
V2
V1+V2+ V3+V4 ≡ Φ''

T3

N
V3
V3+V4 ≡ -Φ'2
23

T2

24  T1  P
V4

T0
112

(1)

Φ

Flux imposé Φ

(2)

Φ'1

Résolution temporelle = r

r

V2+V1

τ1  τ2  τ3  τ4  t(s)

(3)

-Φ'2

V3+V4

r

τ1  τ2  τ3  τ4  t(s)

(4)

Φ''

τ1  τ2  τ3  τ4  t(s)

FIG.5

30
Flux
T2

31
$m_n.Cp_n$

T1
N

$Cp_p = Cp_n$

T0
P
$m_p.Cp_p$
$= (m_n+\Delta m).Cp_p$

32

FIG.6

40
Flux
T2

41
$\{ m_1.Cp_n$

N
$Rth_n$

$Cp_p = Cp_n$

T1

P
$\{ m_p.Cp_p$
$= (m_n+\Delta m).Cp_p$

$Rth_p = Rth_n+\Delta Rth$

T0

42

FIG.7

FIG.8

FIG.9

FIG.10

FIG.11

FIG.12

FIG.13

FIG.14

70

Flux de chaleur Φ

71

N

72

Interconnexion électrique

73

P

P

74

N

Substrat isolant
électrique

$V \equiv \Phi''$

$V \equiv \Phi'$

$V \equiv \Phi$

FIG.15

80

Flux de chaleur Φ

81
Substrat isolant
électrique

P

85

N

82

85

N

83

P

84

$V \equiv \Phi''$

$V \equiv \Phi'$

Via électrique

$V \equiv \Phi$

Interconnexion électrique

## FIG.16

## FIG.17

FIG.18

FIG.19

FIG.20

FIG.21

FIG.22

**EP 2 666 000 B1**

## RÉFÉRENCES CITÉES DANS LA DESCRIPTION

**Documents brevets cités dans la description**

- WO 2008024455 A
- US 5288147 A
- WO 1999019702 A
- GB 2218261 A
- US 7077563 B